(19) Europäisches Patentamt
European Patent Office
Office européen des brevets

(11) **EP 1 797 598 B1**

(12) **EUROPÄISCHE PATENTSCHRIFT**

(45) Veröffentlichungstag und Bekanntmachung des Hinweises auf die Patenterteilung:
**08.09.2010  Patentblatt 2010/36**

(21) Anmeldenummer: **05857307.2**

(22) Anmeldetag: **24.09.2005**

(51) Int Cl.:
**H01L 35/08** *(2006.01)*

(86) Internationale Anmeldenummer:
**PCT/EP2005/010364**

(87) Internationale Veröffentlichungsnummer:
**WO 2006/087018 (24.08.2006 Gazette 2006/34)**

(54) **KONTAKTIERUNG THERMOELEKTRISCHER MATERIALIEN**

THERMOELECTRIC MATERIAL CONTACT

LIAISON DE MATERIAUX THERMOELECTRIQUES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **30.09.2004  DE 102004048219**

(43) Veröffentlichungstag der Anmeldung:
**20.06.2007  Patentblatt 2007/25**

(73) Patentinhaber: **BASF SE**
**67056 Ludwigshafen (DE)**

(72) Erfinder: **STERZEL, Hans-Josef**
**67125 Dannstadt-Schauernheim (DE)**

(56) Entgegenhaltungen:
**EP-A- 0 969 525     EP-A- 1 324 400**
**GB-A- 1 033 018     US-A- 3 859 143**
**US-A- 5 429 680**

EP 1 797 598 B1

**Beschreibung**

Die Erfindung betrifft die temperaturstabile Kontaktierung von halbleitenden Legierungen zum Einsatz in thermoeiektrischen Generatoren und Peltier-Anordnungen sowie Verfahren zur Herstellung von thermoelektrischen Modulen unter Verwendung einer Barriereschicht aus ausgewählten Boriden sowie Nitridenund/oder Siliciden.

Thermoeiektrische Generatoren und Peltier-Anordnungen als solche sind seit langem bekannt. p- und n-dotierte Halbleiter, die auf einer Seite erhitzt und auf der anderen Seite gekühlt werden, transportieren elektrische Ladungen durch einen äußeren Stromkreis. Durch diese thermoelektrischen Generatoren kann an einem Verbraucher im Stromkreis elektrische Arbeit verrichtet werden. Peltier-Anordnungen kehren den zuvor beschriebenen Prozess um.

Einen guten Überblick über thermoelektrische Effekte und Materialien gibt z. B. Cronin B. Vining, ITS Short Course on Thermoelectricity, Nov. 8, 1993 Yokohama, Japan.

Gegenwärtig werden thermoelektrische Generatoren in Raumsonden zur Erzeugung von Gleichströmen, für den kathodischen Korrosionsschutz von Pipelines, zur Energieversorgung von Leucht- und Funkbojen sowie zum Betrieb von Radios und Fernsehapparaten eingesetzt. Die Vorteile der thermoelektrischen Generatoren liegen in ihrer äußersten Zuverlässigkeit: So arbeiten sie unabhängig von atmosphärischen Bedingungen wie Luftfeuchte; es erfolgt kein störungsanfälliger Stofftransport, sondern nur ein Ladungstransport; der Betriebsstoff wird kontinuierlich - auch katalytisch ohne freie Flamme - verbrannt, wodurch nur geringe Mengen an CO, $NO_x$ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit passt sich die thermoelektrische Energiewandlung äußerst flexibel in künftige Bedürfnisse wie Wasserstoffwirtschaft oder Energieerzeugung aus regenerativen Energien ein.

Eine besonders attraktive Anwendung wäre der Einsatz zur Wandlung in elektrische Energie in elektrisch betriebenen Fahrzeugen. Insbesondere bräuchte hierfür keine Änderung am vorhandenen Tankstellennetz vorgenommen zu werden.

Thermoelektrisch aktive Materialien werden im Wesentlichen anhand ihres Wirkungsgrades bewertet. Kennzeichnend für thermoelektrische Materialien ist diesbezüglich der so genannte Z-Faktor (figure of merit):

$$Z = \frac{S^2 \bullet \sigma}{\kappa}$$

mit dem Seebeck-Koeffizienten S [$\mu$V/Grad], der elektrischen Leitfähigkeit $\sigma$ [$\Omega^{-1} \cdot cm^{-1}$] und der Wärmeleitfähigkeit $\kappa$ [mW/cm · Grad]. Gesucht werden dabei thermoelektrische Materialien, die eine möglichst geringe Wärmeleitfähigkeit, eine möglichst große elektrische Leitfähigkeit und einen möglichst großen Seebeck-Koeffizienten aufweisen, so dass der figure of merit einen möglichst hohen Wert annimmt.

Für die Umwandlung thermischer Energie in elektrische beträgt der Wirkungsgrad $\eta$.

$$\eta = \frac{T_{hoch} - T_{niedrig}}{T_{hoch}} \bullet \frac{M - 1}{M + \dfrac{T_{niedrig}}{T_{hoch}}}$$

mit

$$M = \left[ 1 + \frac{Z}{2} (T_{hoch} + T_{niedrig}) \right]^{\frac{1}{2}}$$

$T_{hoch}$ = Temperatur der erhitzten Seite des Halbleiters
$T_{niedrig}$ = Temperatur der gekühlten Seite des Halbleiters

(siehe auch Mat. Sci. and Eng. B29 (1995) 228).

Aus diesem Zusammenhang geht hervor, dass insbesondere thermoelektrische Generatoren dann mit einem hohen Wirkungsgrad arbeiten, wenn die Temperaturdifferenz zwischen heißer und gekühlter Seite möglichst groß ist. Dies bedingt einerseits eine möglichst große Temperaturbeständigkeit des thermoelektrischen Materials - d. h. ein möglichst hoher Schmelzpunkt und möglichst keine Phasenumwandlungen im Anwendungstemperaturbereich - wie auch besonders hohe Anforderung an die Kontaktierung der thermoelektrischen Materialien.

Das Kontaktmaterial soll zur Vermeidung von Verlusten eine möglichst große elektrische und thermische Leitfähigkeit aufweisen. Die mechanische Festigkeit soll möglichst groß sein, das Kontaktmaterial darf sich im Betrieb nicht ablösen, es darf nicht abplatzen.

Es darf auch nicht - und dies ist besonders bei hohen Arbeitstemperaturen kritisch - ganz oder teilweise in die Halbleiter eindiffundieren. In diesem Fall würden dort die Zusammensetzung geändert und die thermoelektrischen Eigenschaften in stark negativer Weise erniedrigt werden.

Diese Problematik zeigt sich beispielsweise leicht beim Bleitellurid als thermoelektrischem Material (s. Review of Lead-Telluride Bonding Concepts, Mat. Res. Soc. Symp. Proc., Vol. 234, 1991, Seiten 167-177):

Nahezu jedes als Lotkomponente in Frage kommende Element reagiert mit Tellur, wodurch das empfindliche Pb : Te-Verhältnis unzulässig geändert wird. Dies betrifft auch Dotierstoffe, wodurch beispielsweise ein n-leitendes Material in ein p-leitendes und umgekehrt überführt wird.

Als Lösungen werden beispielsweise formstabile, federnde Kontaktierungen diskutiert, die aber sowohl teuer wie auch unreproduzierbar in der flächigen Kontaktierung selbst sind.

Auch Schweißverbindungen werden diskutiert. Beim Schweißen besteht der Vorteil, dass kein zusätzlicher Werkstoff zwischen Kontaktmaterial und Halbleiter eingebracht wird. Allerdings wird der Halbleiter zumindest kurzzeitig teilweise aufgeschmolzen mit den Nachteilen, dass beim Erkalten die aufgeschmolzene Schicht mit einem anderen Gefüge rekristallisiert und dass die Diffusion von Kontaktwerkstoff in die Schmelze extrem groß ist.

Nach dem Stand der Technik sind deshalb Lötverfahren bevorzugt mit den Vorteilen, dass das Löten 100 bis 200°C unterhalb der Schmelztemperatur der Halbleiter stattfindet und dass das flüssige Lot auch kleine Risse und Unebenheiten in vorteilhafter Neise ausfüllt, was eine hohe elektrische und thermische Leitfähigkeit ergibt.

Lote nach dem Stand der Technik sind üblicherweise Legierungen, die Bismut, Antimon, Zinn, Blei, Kupfer und/oder Silber enthalten. Die Schmelzpunkte liegen üblicherweise unterhalb von 400°C.

Es sind keine Lötverbindungen bekannt, die oberhalb 400°C diffusionsfest wären. Im Gegenteil: Eine Randbedingung für eine gute Lötverbindung besteht darin, dass zumindest eine Legierungskomponente des Lots in die zu verbindenden Werkstoffe eindiffundiert.

Damit wird ausgesagt, dass es von vornherein keine hochtemperaturstabilen, diffusionsfesten Lötverbindungen gibt.

Offensichtlich deshalb wurde bereits vorgeschlagen, zwischen das Kontaktmaterial und die Halbleiter eine Barriereschicht einzubringen (JP 2002 - 043637). Diskutiert werden Barriereschichten aus Nickelphosphiden, Nickelboriden und eine zusätzliche Schicht aus Gold.

Dennoch erfordern auch Barriereschichten zur Verbindung mit dem Kontaktmaterial ein zusätzliches Lot, das die Aufgabe hat, die Barriereschicht fest mit dem Kontaktmaterial zu verbinden.

US 5429680 A beschreibt spezielle thermoelektrische Module für Wärmepumpen. Hier wird eine Barriereschicht u. a. aus Nickelboriden und -phosphiden offenbart.

US 3859143 A beschreibt ein thermoelektrisches Element, wobei das thermoelektrische Material mit einer Barriereschicht aus Carbiden versehen ist.

EP 1324400 A setzt bei der Herstellung eines thermoelektrischen Moduls zwar nickelhaltige Lote ein, die eingesetzten thermoelektrischen Materialien basieren allerdings auf Silicium bzw. Si-haltigen Legierungen mit hohem Si-Anteil, sodass hier völlig andere Barrierematerialien notwendig werden als für Telluride.

Im Stand der Technik werden die Probleme, die beim Einsatz konventioneller Lote auftreten, nicht angegangen. Es werden insbesondere keine geeigneten Kombinationen von Lot und Barrierematerial zur Verfügung gestellt, die bei hohen Temperaturen gute Ergebnisse erwarten lassen.

Aufgabe der Erfindung war es, eine geeignete Kombination von Lot und Barrierematerial zur Verfügung zu stellen, die auch bei erhöhten Temperaturen von oberhalb 400°C sowohl eine sichere mechanische Verbindung als auch konstante, gute Langzeiteigenschaften des thermoelektrischen Materials gewährleistet.

Die Aufgabe wurde dadurch gelöst, dass man das thermoelektrisch halbleitende Material mit einer Barriereschicht aus ausgewählten Boriden sowie Nitriden und/oder Siliciden versieht und diese Schicht mit dem eigentlichen Kontaktmaterial durch Löten verbunden wird.

Gegenstand der Erfindung sind somit thermoelektrische Module, die **dadurch gekennzeichnet sind, dass** das thermoelektrisch halbleitende Material mit einer Barriereschicht aus $TiB_2$, $ZrB_2$, $HfB_2$, $VB_2$, $NbB_2$, $TaB_2$, $CrB_2$, $Mo_2B_5$,

W$_2$B$_5$, FeB, CoB, Nitriden und/oder Siliciden versehen ist und diese Schicht mit dem eigentlichen Kontaktmaterial durch Löten verbunden ist, wobei das Lotmaterial Legierungen des Nickels enthält.

Gegenstände der Erfindung sind weiterhin ein Verfahren zur Herstellung solcher thermoelektrischer Module sowie thermoelektrische Generatoren oder Peltier-Anordnungen, die solche thermoelektrischen Module enthalten.

Die Erfindung ist bei allen bekannten thermoelektrisch halbleitenden Materialen anwendbar. Geeignete Materialien sind beispielsweise beschrieben in Mat. Sci. and Eng. B29 (1995) 228. Besonders vorteilhaft ist sie bei Halbleitern auf der Basis von Telluriden. Dabei handelt es sich im Allgemeinen um bekannte Telluride, wie Bleitellurid sowie dessen Abwandlungen, in welchen Blei durch Elemente wie Zinn sowie Tellur teilweise durch Selen ersetzt sind.

Es könne auch substituierte Halbleitermaterialen, wie beispielsweise Telluride, bei denen die positiv polarisierten Atome des Kristallgitters des Tellurids partiell durch Silizium und/oder Germanium substituiert sind, eingesetzt werden. Eine typische Zusammensetzung eines Materials in diesem Sinne ist z. B. PbTe · (Si$_2$Te$_3$)$_{0,01}$. Unter "partiell" wird dabei ein Substitutionsgrad mit vorzugsweise 0,002 bis 0,05 Mol, besonders bevorzugt 0,003 bis 0,02 Mol, insbesondere 0,008 bis 0,013 Mol, pro Mol Formeleinheit Tellurid verstanden. Solche substituierten Telluride, deren Herstellung und Eigenschaften sind beispielsweise beschrieben in der DE-Patentanmeldung Nr. 102004025066.9.

Die beschriebenen unsubstituierten oder substituierten Halbleitermaterialien können ohne weitere Dotierung eingesetzt werden. Sie können aber auch weitere Verbindungen, insbesondere sonstige üblicherweise mitverwendete Dotiermittel enthalten.

Insbesondere die Telluride können zusätzlich dotiert sein. Wenn die Telluride dotiert sind, so beträgt der Anteil an Dotierungselementen vorzugsweise bis zu 0,1 Atom-% ($10^{18}$ - $10^{19}$ Atome pro Kubikzentimeter Halbleitermaterial), besonders bevorzugt bis zu 0,05 Atom-%, insbesondere bis zu 0,01 Atom-%.

Dotiert wird mit Elementen, die einen Elektronenüber- oder -unterschuss im Kristallgitter bewirken. Geeignete Dotiermetalle für p-Halbleiter sind beispielsweise die folgenden Elemente: Lithium, Natrium, Kalium, Magnesium, Kalzium, Strontium, Barium und Aluminium. Geeignete Dotiermetalle für n-Halbleiter sind die Elemente Chlor, Brom und Jod.

Durch Dotieren lässt sich der Leitungstyp in das Gegenteil überführen.

Die erfindungsgemäß eingesetzten thermoelektrisch halbleitenden Materialen werden mit einer Barriereschicht versehen. Die Barriereschicht besteht aus sehr gut elektrisch leitfähigen Verbindungen mit starrem Kristallgitter, wodurch die Diffusion durch diese Schichten verhindert wird.

Erfindungsgemäß besteht die Barriereschicht aus TiB$_2$, ZrB$_2$, HfB$_2$, VB$_2$, NbB$_2$, TaB$_2$, CrB$_2$, Mo$_2$B$_5$, W$_2$B$_5$, FeB, CoB, Nitriden, Carbiden und/oder Siliciden.

Im Einzelnen kommen hierfür, neben den genannten Boriden, beispielhaft folgende Verbindungen in Frage:

Nitride wie TiN, TaN, CrN, ZrN, AlTiN;
oder
Silizide wie VSi$_2$, NbSi$_2$, TaSi$_2$, TiSi$_2$, ZrSi$_2$, MoSi$_2$, WSi$_2$.

Geeignet sind auch Mischungen dieser Verbindungen untereinander.

Die Halbleiter werden vor oder nach ihrer Zerteilung auf die Anwendungsdimensionen beidseitig mit der oben beschriebenen Barriereschicht versehen. Diese kann nach verschiedenen Verfahren aufgebracht werden, beispielsweise durch Sputtern ausgehend von einem Target der gleichen Zusammensetzung, wie beispielsweise beschrieben in J. Appl. Phys., Vol. 79 Nr. 2, 1109-1115, 1996, oder von M.E. Thomas et al., VLSI Multilevel Interconnection Conference Proceedings, Fifth Int. IEEE, 1988 , oder durch "Physical Vapour Deposition", wie beispielsweise beschrieben in D. S. Dickerby, A. Matthews, Advanced Surface Coutings, Blackie, Glasgow, 1991 und Handbook of Physical Vapor Deposition (PVD) Processing, ISBN 0-8155-1422-0, erzeugt werden.

Die Verbindung der Barriereschicht mit dem Kontaktmaterial erfolgt durch Löten.

Vorteilhafterweise werden als Lotmaterial Legierungen des Nickels verwendet, insbesondere Legierungen des Nickels mit Mg, Sn oder Zn.

Besonders gute Ergebnisse zeigen Kombinationen mit den folgenden Legierungen als Lotmaterial:

Mg$_2$Ni (Schmelzpunkt ca. 760°C),
Ni$_3$Sn$_4$ (Schmelzpunkt ca. 794°C),
Zn/Ni mit 70 bis 95 Gew.-% Zn (beispielsweise bei 90 Gew.-% Zn, Schmelzpunkt ca. 800°C).

Zur Erhöhung des Schmelzpunkts wird der Ni-Anteil erhöht und zu dessen Absenkung umgekehrt der Ni-Anteil verkleinert.

Aufgrund ihres Ni-Gehalts gehen die Lotmaterialien eine gute Verbindung mit den Barriereschichten ein.

Das Lotmaterial dient zur Verbindung der Barriereschichten mit den eigentlichen Kontaktblechen. Das Auftragen des Lotmaterials kann auf jede geeignete Weise erfolgen. Vorteilhaft ist es, das Lotmaterial durch thermisches Spritzen auf das eigentliche Kontaktblech aufzubringen.

Zum Löten werden in diesem Falle die Kontaktstellen entweder von außen thermisch auf die notwendige Temperatur gebracht oder man führt ein Widerstandslöten durch, bei dem die unverlöteten Kontakte durch Stromdurchfluss auf die Löttemperatur gebracht werden. Das Widerstandslöten hat den Vorteil einer Selbstregelung: Solange die Lötstelle nicht vollflächig verlötet ist, weist sie einen erhöhten elektrischen Widerstand auf, es fällt mehr Spannung ab und bei konstantem Strom fällt mehr Leistung ab.

Damit wird die Lötstelle heißer. Bei flächigem Verlauf des Lots sinkt der Widerstand und damit die Temperatur.

Es können aber auch andere Verfahren des Standes der Technik zum Aufbringen des Lotmaterials und zum Löten eingesetzt werden. Eine gute Übersicht über gegenwärtig angewandte Lötverfahren gibt die Firmenschrift "Lötverfahren" der Firma Braze Tec GmbH (www.BrazeTec.de).

Die Löttemperatur ist den verwendeten Materialien anzupassen und liegt vorteilhafterweise bei 10 bis 100°C oberhalb der Liquidustemperatur des Lots. Die Lötzeiten sind den jeweiligen Bedingungen von Wärmekapazität und Wärmeleitfähigkeit anzupassen.

Das erfindungsgemäße Verfahren hat den Vorteil, dass das Kontaktmaterial auch bei hohen Temperaturen nicht in die Halbleiter eindiffundiert, damit die Zusammensetzung des Halbleitermaterials nicht geändert wird und somit die thermoelektrischen Eigenschaften nicht negativ beeinflusst werden. Durch Einsatz der beschriebenen Barriereschichten weisen die erfindungsgemäßen thermoelektrischen Module im Vergleich zu denen mit herkömmlichen Barriereschichten eine größere Einsatztemperaturbeständigkeit auf.

Thermoelektrische Generatoren oder Peltier-Anordnungen mit den beschriebenen thermoelektrischen Modulen sind besonders geeignet für den Einsatz bei erhöhten Temperaturen von größer als 300°C.

**Patentansprüche**

1. Thermoelektrische Module, **dadurch gekennzeichnet, dass** das thermoelektrisch halbleitende Material mit einer Barriereschicht aus $TiB_2$, $ZrB_2$, $HfB_2$, $VB_2$, $NbB_2$, $TaB_2$, $CrB_2$, $Mo_2B_5$, $W_2B_5$, FeB, CoB, Nitriden und/oder Siliciden versehen ist und diese Schicht mit dem eigentlichen Kontaktmaterial durch Löten verbunden ist, wobei das Lotmaterial Legierungen des Nickels enthält.

2. Thermoelektrische Module nach Anspruch 1, **dadurch gekennzeichnet, dass** das Lotmaterial Legierungen des Nickels mit Mg, Sn oder Zn enthält.

3. Verfahren zur Herstellung thermoelektrischer Module, **dadurch gekennzeichnet, dass** auf das thermoelektrisch halbleitende Material eine Barriereschicht aus $TiB_2$, $ZrB_2$, $HfB_2$, $VB_2$, $NbB_2$, $TaB_2$, $CrB_2$, $Mo_2B_5$, $W_2B_5$, FeB, CoB, Nitriden und/oder Siliciden aufgebracht wird und anschließend diese Schicht mit dem eigentlichen Kontaktmaterial durch Löten verbunden wird, wobei als Lotmaterial Legierungen des Nickels eingesetzt werden.

4. Verfahren gemäß Anspruch 3, **dadurch gekennzeichnet, dass** das Lotmaterial durch thermisches Spritzen auf das Kontaktblech aufgebracht wird.

5. Verfahren gemäß Anspruch 3 oder 4, **dadurch gekennzeichnet, dass** die Verbindung der Barriereschicht mit dem Kontaktmaterial durch Widerstandslöten erfolgt.

6. Thermoelektrischer Generator oder Peltier-Anordnung, enthaltend thermoelektrische Module gemäß Anspruch 1 oder 2.

**Claims**

1. A thermoelectric module, wherein the thermoelectrically semiconductive material has been provided with a barrier layer composed of $TiB_2$, $ZrB_2$, $HfB_2$, $VB_2$, $NbB_2$, $TaB_2$, $CrB_2$, $Mo_2B_5$, $W_2B_5$, FeB, CoB, nitrides and/or silicides, and this layer has been bonded to the actual contact material by soldering, the solder material comprising alloys of nickel.

2. The thermoelectric module according to claim 1, wherein the solder material comprises alloys of nickel with Mg, Sn or Zn.

3. A process for producing thermoelectric modules, wherein a barrier layer composed of $TiB_2$, $ZrB_2$, $HfB_2$, $VB_2$, $NbB_2$, $TaB_2$, $CrB_2$, $Mo_2B_5$, $W_2B_5$, FeB, CoB, nitrides and/or silicides is applied to the thermoelectrically semiconductive material and this layer is subsequently bonded to the actual contact material by soldering, the solder material used comprising alloys of nickel.

4. The process according to claim 3, wherein the solder material is applied to the contact sheet by thermal spraying.

5. The process according to claim 3 or 4, wherein the barrier layer is bonded to the contact material by resistance soldering.

6. A thermoelectric generator or Peltier arrangement comprising thermoelectric modules according to claim 1 or 2.

**Revendications**

1. Modules thermoélectriques, **caractérisés en ce que** le matériau thermoélectrique semi-conducteur est pourvu d'une couche formant une barrière en $TiB_2$, $ZrB_2$, $HfB_2$, $VB_2$, $NbB_2$, $TaB_2$, $CrB_2$, $Mo_2B_5$, $W_2B_5$, FeB, CoB, nitrures et/ou siliciures et cette couche est assemblée par brasage avec le matériau formant le contact en soi, le matériau de brasage contenant des alliages du nickel.

2. Modules thermoélectriques selon la revendication 1, **caractérisés en ce que** le matériau de brasage contient des alliages du nickel avec Mg, Sn ou Zn.

3. Procédé pour la fabrication de modules thermoélectriques, **caractérisé en ce qu'**une couche formant une barrière en $TiB_2$, $ZrB_2$, $HfB_2$, $VB_2$, $NbB_2$, $TaB_2$, $CrB_2$, $Mo_2B_5$, $W_2B_5$, FeB, CoB, nitrures et/ou siliciures est appliquée sur le matériau thermoélectrique semi-conducteur, puis cette couche est assemblée par brasage avec le matériau formant le contact en soi, où on utilise comme matériau de brasage des alliages du nickel.

4. Procédé selon la revendication 3, **caractérisé en ce que** le matériau de brasage est appliqué par pulvérisation thermique sur la tôle formant le contact.

5. Procédé selon la revendication 3 ou 4, **caractérisé en ce que** l'assemblage de la couche formant une barrière avec le matériau formant le contact est réalisé par brasage par résistance.

6. Générateur thermoélectrique ou disposition de Peltier contenant des modules thermoélectriques selon la revendication 1 ou 2.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- JP 2002043637 A
- US 5429680 A
- US 3859143 A
- EP 1324400 A
- DE 102004025066

### In der Beschreibung aufgeführte Nicht-Patentliteratur

- **Cronin B. Vining.** ITS Short Course on Thermoelectricity. Yokohama, 08. November 1993
- *Mat. Sci. and Eng.,* 1995, vol. B29, 228
- Lead-Telluride Bonding Concepts. *Mat. Res. Soc. Symp. Proc.,* 1991, vol. 234, 167-177
- *J. Appl. Phys.,* 1996, vol. 79 (2), 1109-1115
- **M.E. Thomas et al.** VLSI Multilevel Interconnection Conference Proceedings. *Fifth Int. IEEE,* 1988
- **D. S. Dickerby ; A. Matthews.** Advanced Surface Coutings. Blackie, 1991
- Handbook of Physical Vapor Deposition (PVD) Processing